# EUROPEAN PATENT SPECIFICATION

(11) **EP 0 460 785 B1**
(45) Date of publication and mention of the grant of the patent: **17.04.1996**
(21) Application number: 91300584.9
(22) Date of filing: 25.01.1991
(51) Int. Cl.: H01L 23/373, H01L 21/48

(54) **Semiconductor device having a heat sink**
Halbleiteranordnung mit einer Wärmesenke
Dispositif semi-conducteur comprenant un refroidisseur

(30) Priority: 05.06.1990 JP 147761/90
(43) Date of publication of application: 11.12.1991
(73) Proprietor: MITSUBISHI DENKI KABUSHIKI KAISHA, Tokyo (JP)
(72) Inventor: Shigihara, Kimio, c/o Mitsubishi Denki K.K., 4-chome, Itami-shi, Hyogo-ken (JP); Nagai, Yutaka, c/o Mitsubishi Denki K.K., 4-chome, Itami-shi, Hyogo-ken (JP); Aoyagi, Toshitaka, c/o Mitsubishi Denki K.K., 4-chome, Itami-shi, Hyogo-ken (JP)
(74) Representative: Beresford, Keith Denis Lewis

(56) References cited:
- WO-A-88/01437
- US-A- 4 698 662
- NAVY TECHNICAL DISCLOSURE BULLETIN, vol. 7, no. 3, March 1982, pages 25-29, Washington, US; J.E. DAVEY et al.: "Heat sinks for GaAs integrated circuits by heterostructures"
- IDEM
- IBM TECHNICAL DISCLOSURE BULLETIN, vol. 23, no. 5, October 1980, pages 2146- 2147, New York, US; L.D. COMERFORD: "Flip-chip bonding by solder filling of capillaries"

## Description

### FIELD OF THE INVENTION

The present invention relates to a semiconductor device and a method for manufacturing the same and, more particularly, to a semiconductor device and a method for manufacturing the same capable of reducing thermal resistance and increasing a life of a semiconductor element by reducing stress applied to the semiconductor element.

### BACKGROUND OF THE INVENTION

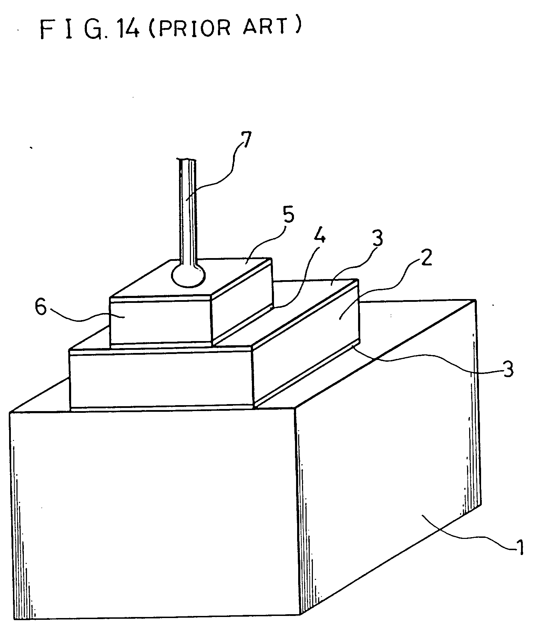

Figure 14 is a perspective view showing a conventional semiconductor laser device disclosed in, for example "MITSUBISHI DENKI GIHO", Vol. 60, No.12, pp. 27 to 31, 1986. In figure 14, reference numeral 1 designates a heat sink formed of silver or diamond. A submount 2 formed of Si crystal is disposed on the heat sink 1. Gold gilding films 3 are formed on upper and lower surfaces of the submount 2. A semiconductor laser chip 6 is disposed on the submount 2. A p side electrode or an n side electrode 4 and an n side electrode or a p side electrode 5 are formed on lower and upper surfaces of the laser chip 6, respectively. Especially, the surface of the electrode 4 opposed to the submount 2 is plated with gold. A wire 7 is bonded to the electrode 5.

Next, description will be given of a method for reducing stress applied to the semiconductor laser chip in the prior art. Since the heat sink 1 is formed of metal and the laser chip 6 is formed of a semiconductor, there is a large difference between thermal expansion coefficients thereof. For example, when the heat sink 1 is formed of silver and the laser chip 6 is formed of GaAs semiconductor, the thermal expansion coefficients of the heat sink and the laser chip are approximately 19.5 x 10⁻⁶ / °C and 6.5 X 10⁻⁶ / °C, respectively. In general, the laser chip 6 is attached to the heat sink 1 using an appropriate soldering material at a high temperature. When the high temperature falls to a room temperature (low temperature), stress is applied to the laser chip 6 because of the above-described difference in thermal expansion coefficient, with the result that a laser characteristic is degraded. In order to avoid this problem, the submount 2 formed of Si crystal is inserted between the heat sink 1 and the laser chip 6 in the prior art. Since the thermal expansion coefficient of the Si crystal is relatively close to that of GaAs and the submount 2 formed of the Si crystal has an appropriate thickness (approximately 150 µm) the stress generated by the difference in thermal expansion coefficient is reduced because of the submount 2, so that the stress is not applied to the laser chip 6.

In addition, there is another method for reducing the stress applied to the laser chip 6, in which the laser chip 6 is bonded to the heat sink 1 using a soldering material having a relatively low melting point (for example InPb).

As described above, according to the conventional semiconductor laser, since Si crystal having a thickness of approximately 150 µm is inserted between the heat sink and the laser chip as a submount, a heat generated in the laser chip is hardly conducted. Therefore, it is not suitable for high output and high current injection operation.

In addition, according to the method using the soldering material having a low melting point, a wire has to be attached at a lower temperature in the future step and the wire is not reliably attached.

### SUMMARY OF THE INVENTION

The present invention is intended as a solution to the problems aforesaid. In particular it is intended to provide a semiconductor device having a long life in which stress applied to a semiconductor element can be reduced and also heat generated by the semiconductor element can be reliably radiated.

In accordance with the first aspect of the present invention there is provided a semiconductor device comprising:
a heat sink for radiating heat; and
a semiconductor element, of a type generating heat during its operation, mounted on a major surface of said heat sink;
which semiconductor device is characterised by:
an amorphous semiconductor film located between said heat sink and said semiconductor element.

Since amorphous semiconductor film is included between the semiconductor element and the heat sink any stress applied to the semiconductor element due to differences in thermal expansion can be reduced. Thermal resistance also is reduced with the result that the life of the semiconductor device is extended.

The amorphous semiconductor film may, for example, be of amorphous silicon or of amorphous germanium. When first and second metal films are disposed between the heat sink and the amorphous semiconductor film and between the amorphous semiconductor film and the semiconductor element, respectively, not only is the stress applied to the semiconductor element reduced but also good ohmic contact can be achieved by alloys formed between the amorphous semiconductor film and the first and second metal films. The metal films, for example, may be of gold and gold-silicon or gold-germanium alloys may be formed. A high bonding strength and improved electrical conductivity can be achieved by this means.

The amorphous semiconductor film may be restricted to a region which lies between the semiconductor element and the heat sink and a metal film of lower electrical resistance than the amorphous semiconductor film may be provided covering the amorphous semiconductor film and the adjacent surface of the heat sink. In this arrangement current flow and heat flow are differentiated and provide further reduction in stress, further reduction in thermal resistance and improved electrical conductivity.

Alternatively, the amorphous semiconductor film can cover the major surface of the heat sink, and a metal film disposed is on the amorphous semiconductor film. An electrical wire can be bonded to this metal film and electrical current flow and heat flow can be differentiated as before.

In accordance with a second aspect of the present invention there is provided a method for manufacturing a semiconductor device having a function of radiating heat generated therein, comprising the steps of:
forming a first metal film on a heat sink for radiating heat;
forming an amorphous semiconductor film on said first metal film and then forming a second metal film on said amorphous semiconductor film;
placing a semiconductor element on said second metal film; and
urging said semiconductor element and said second metal film together and heating at the same time, to bond said semiconductor element to said heat sink.

In this method the semiconductor element is bonded to the heat sink whilst sintering and bonding operation is performed simultaneously. No high temperature is required for this processing and oxidation of the amorphous semiconductor film is avoided and the electrical characteristics are improved as a result.

In this method the amorphous semiconductor film may be of amorphous silicon or amorphous germanium and alloys may be formed between the amorphous semiconductor film and the first and second metal films.

Insofar as this method involves the incorporation of an amorphous semiconductor film, it is acknowledged that amorphous semiconductor films have been employed during the production of semiconductor devices incorporating heat sinks. Navy Technical Disclosure Bulletin, Vol.7, No. 3, March 1982, pp 25-29, Washington U.S., J.E. Davey et al "Heat Sinks for GaAs Integrated Circuits by Heterostructures" describes a method of heat sink assembly during which amorphous layers of silicon and germanium are deposited on the surface of a single crystal silicon substrate. These amorphous layers are annealed and converted to single crystal prior to completion of the assembly. Amorphous layers are not present in the semiconductor device produced.

Other aspects and advantages of the present invention will become apparent from the detailed description given hereinafter; it should be understood, however, that the detailed description and specific embodiment are given by way of illustration only, since various changes and modifications within the scope of the invention will become apparent to those skilled in the art from this detailed description.

### BRIEF DESCRIPTION OF THE DRAWINGS

Figure 1 is a perspective view showing a semiconductor laser as a semiconductor device in accordance with a first embodiment of the present invention;
Figure 2 is a perspective view showing a semiconductor laser as a semiconductor device in accordance with a second embodiment of the present invention;
Figures 3(a) to 3(e) are perspective views showing manufacturing steps of the semiconductor device shown in figure 2;
Figure 4 is a perspective view showing a semiconductor laser as a semiconductor device in accordance with a third embodiment of the present invention;
Figures 5(a) to 5(f) are perspective views showing manufacturing steps of the semiconductor device shown in figure 4;
Figure 6(a) is a graph showing an operation current which varies with time when light is constantly outputted (1W, 25°C) from the semiconductor device in figure 2;
Figure 6(b) is a graph showing an operation current which varies with time when light is constantly outputted (1W, 25°C) from a semiconductor laser in which a semiconductor laser chip is directly bonded to a heat sink by gold-silicon solder;
Figure 7 is a perspective view showing a semiconductor laser as a semiconductor device in accordance with a fourth embodiment of the present invention;
Figure 8 is a view showing a manufacturing step of the semiconductor device shown in figure 7;
Figure 9 is an enlarged view showing a part where a chip of the semiconductor device in figure 7 is attached;
Figures 10(a) to 10(e) are perspective views showing a semiconductor laser as a semiconductor device and its manufacturing steps in accordance with a fifth embodiment of the present invention;
Figure 11 is a view showing a laser chip before it is attached onto the heat sink of a semiconductor laser as a semiconductor device in accordance with a sixth embodiment of the present invention;
Figure 12 is a perspective view showing a semiconductor laser as a semiconductor device in accordance with a seventh embodiment of the present invention;
Figures 13(a) to 13(f) are perspective views showing manufacturing steps of the semiconductor device shown in figure 12; and
Figure 14 is a perspective view showing a conventional semiconductor laser device.

### DESCRIPTION OF THE PREFERRED EMBODIMENTS

Embodiments of the present invention will be described in detail hereinafter with reference to the drawings.

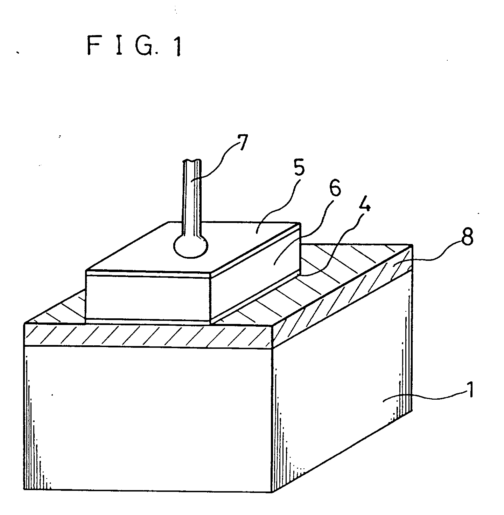

Figure 1 is a perspective view showing a semiconductor laser as a semiconductor device in accordance with a first embodiment of the present invention. In figure 1, reference numeral 1 designates a heat sink formed of, for example silver. An amorphous semiconductor film 8 is arranged on the heat sink 1 and a semiconductor laser chip 6 is put on the heat sink 1 via the amorphous semiconductor film 8. Reference numeral 4 designates a p side electrode or an n side electrode of the semiconductor laser chip 6 and reference numeral 5 designates an n side electrode or p side electrode thereof. A wire 7 is bonded to the electrode 5.

Manufacturing steps of this first embodiment of the present invention will be described hereinafter.

First, the heat sink 1 formed of, for example silver or diamond is prepared. The amorphous semiconductor film 8 is formed on the heat sink 1 by electron beam evaporation or sputtering. In addition, a temperature of the heatsink when the amorphous semiconductor film is formed is approximately 200°C. Then, the semiconductor laser chip 6 having the electrodes 4 and 5 formed on both surfaces thereof is fixed onto the amorphous semiconductor film 8 using an appropriate soldering material. Finally, the wire 7 is bonded to the electrode 5 of the semiconductor laser chip 6 and then the semiconductor laser shown in figure 1 is completed.

Next, operation of this first embodiment of the present invention will be described hereinafter.

According to the first embodiment of the present invention, the amorphous semiconductor film 8 formed of, for example amorphous silicon is inserted between the heat sink 1 and the semiconductor laser chip 6. Conventionally, the heat sink and the semiconductor laser are bonded at a relatively high temperature of approximately 300 to 400°C and therefore, when the temperature falls to a room temperature, stress is applied to the semiconductor laser chip. Even when the semiconductor laser operates normally, heat is generated in the semiconductor laser chip. Since a thermal expansion coefficient of a crystal which constitutes the semiconductor laser chip is different from that of the heat sink, stress is applied to the semiconductor laser chip even during its operation. Thus, the semiconductor laser cannot operate for a long time. By contrast, amorphous semiconductor used in the first embodiment of the present invention has various lattice constants unlike the crystal semiconductor. Therefore, stress generated by the difference between the thermal expansion coefficients of the semiconductor laser chip and the heat sink is not applied to the semiconductor laser chip but is applied to the amorphous semiconductor film in the structure shown in figure 1. Thus, the semiconductor laser can operate for a long time. In addition, according to a conventional example in figure 14, a Si crystal having a thickness of approximately 150 µm is used for reducing the stress, so that thermal resistance is considerably high. Meanwhile, the amorphous semiconductor film in accordance with the first embodiment of the present invention has a function of effectively reducing stress even if it has a quite thin thickness of approximately 300 nm (3000 Å), with the result that the thermal resistance can be reduced.

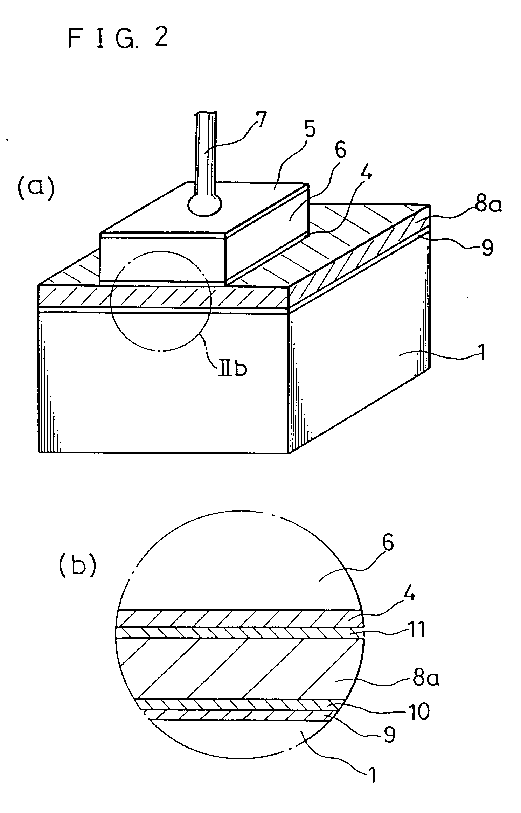

Figure 2(a) is a perspective view showing a semiconductor laser as a semiconductor device in accordance with a second embodiment of the present invention and figure 2(b) is an enlarged view showing a part of IIb in figure 2(a). In figure 2, the same references as in figure 1 designate the same or corresponding parts. A metal film 9 is formed on the heat sink 1 by gold gilding and amorphous silicon or amorphous germanium 8a is formed on the metal film 9. An alloy film 10 is formed between the amorphous silicon or amorphous germanium 8a and the metal film 9 and an alloy film 11 is formed between the amorphous silicon or amorphous germanium 8a and the p side electrode (or n side electrode) 4.

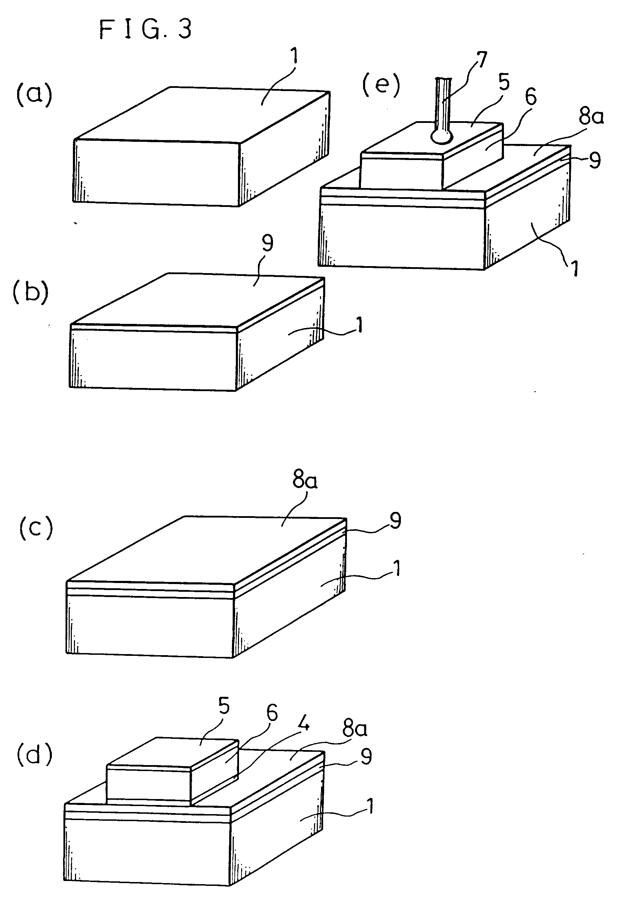

Figures 3(a) to 3(e) are perspective views showing manufacturing steps for the semiconductor laser device in accordance with the second embodiment of the present invention.

First, referring to figure 3(a), the heat sink 1 formed of, for example silver or diamond is prepared. Then, referring to figure 3(b), the metal film 9 is formed on the heat sink 1 by gold gilding. Then, referring to figure 3(c), the amorphous semiconductor film 8a formed of amorphous silicon or amorphous germanium is formed on the metal film 9 by electron beam evaporation or sputtering. The temperature of the heat sink 1 and metal film 9 when the amorphous semiconductor film is formed is approximately 200°C. Then, referring to figure 3(d), the semiconductor laser chip 6 having the electrodes 5 and 4 formed on upper and bottom surfaces thereof, respectively, is put on the amorphous semiconductor film 8a and then heated up, while pressure or weight is applied from above. Then, the alloy films are formed between the amorphous semiconductor film 8a and the metal film 9 and the electrode 4, whereby the laser chip 6 is fixed onto the amorphous semiconductor film 8a without using a soldering material. Finally, referring to figure 3(e), the wire 7 is bonded to the electrode 5 of the semiconductor laser chip 6 and then the semiconductor laser is completed.

Next, operation thereof in accordance with this embodiment of the present invention will be described hereinafter.

According to the second embodiment of the present invention, the amorphous semiconductor film 8a formed of amorphous silicon or amorphous germanium is inserted between the semiconductor laser chip 6 and the heat sink 1 and the metal film 9 is provided on the heat sink. When the amorphous semiconductor film formed of amorphous silicon or amorphous germanium and the metal film are bonded and heated up, the alloy film 10 is formed at the bonding region. Similarly, the alloy film 11 is formed between the electrode 4 of the semiconductor laser and the amorphous semiconductor film formed of amorphous silicon or amorphous germanium. As a result, the same effect as in the first embodiment can be attained and sufficient structural strength can be obtained without using any soldering material, so that the construction work can be simple. Furthermore, since ohmic contact is made by these alloy films, the electrical characteristics are improved.

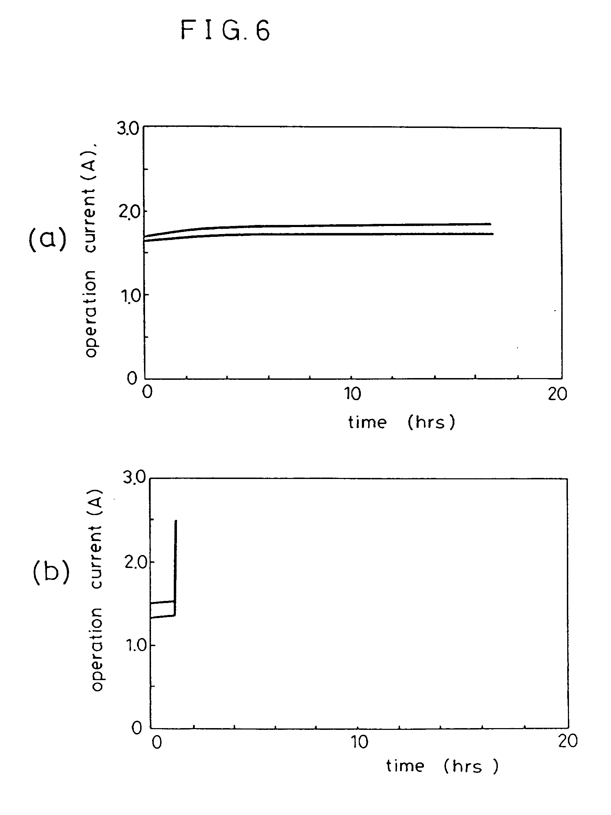

Figure 6 shows data for describing effectiveness of the present invention. Figure 6(a) shows a result of an operation test of the semiconductor laser device when amorphous silicon having a thickness of approximately 300 nm (3000Å), silver, and gold gilding film are used as the amorphous semiconductor film, the heat sink, and the metal film, respectively under conditions that an ambient temperature is 25°C and an optical output is 1W. Figure 6(b) shows an example when the silver heat sink is directly bonded to the semiconductor laser chip using a gold-silicon soldering material under the same conditions for comparison. As can be seen from the figure, in case of performing direct bonding, all elements are degraded within two hours because stress is applied to the semiconductor laser chip. On the other hand, according to the present invention, stable operation can be continuously obtained for a long time. In addition, in case of a conventional one using Si crystal having a thickness of 150 µm an optical output does not satisfy the operation condition because thermal resistance is too high.

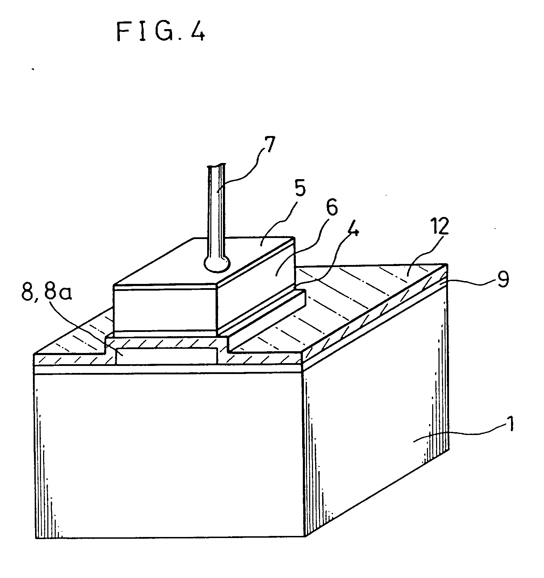

Figure 4 is a perspective view showing a semiconductor laser as a semiconductor device in accordance with a third embodiment of the present invention. In figure 4, the same references as in figures 1 and 2 designate the same or corresponding parts. Reference numeral 12 designates an electrically conductive metal film provided on the amorphous semiconductor film 8 or 8a and the metal film 9.

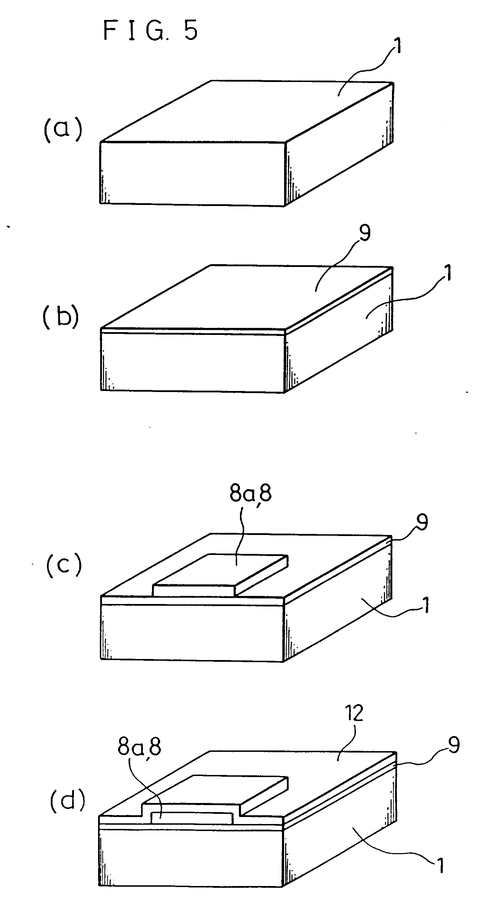

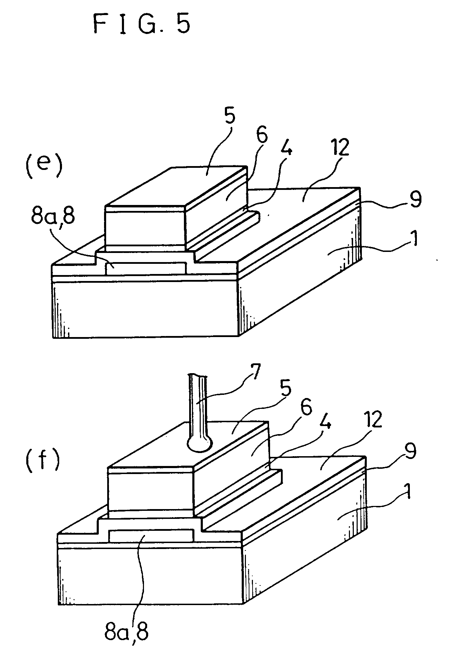

Figures 5(a) to 5(f) are perspective views showing manufacturing steps of the semiconductor laser in accordance with the third embodiment of the present invention.

Then, the manufacturing steps of the semiconductor laser in accordance with the third embodiment of the present invention are described hereinafter.

Referring to figure 5(a), the heat sink 1 formed of, for example silver or diamond is prepared. Then, referring to figure 5(b), the metal film 9 is formed on the heat sink 1 by, for example gold gilding. Then, the amorphous semiconductor film is formed by electron beam evaporation or sputtering. Similar to the first and second embodiments of the present invention, when the amorphous semiconductor film is formed, the temperature of the heat sink 1 and metal film 9 is approximately 200°C. Then, the amorphous semiconductor film 8 or 8a is formed so as to be about the same size as that of the semiconductor laser chip by etching as shown in figure 5(c). The amorphous semiconductor film can be formed also by a lift-off method other than the above-described etching. According to this method, an oxide film or the like is formed on a part of the metal film 9 where the amorphous semiconductor film 8 or 8a is not to be formed before the amorphous semiconductor film is formed on the metal film 9 and then the amorphous semiconductor film is formed on the metal film 9 including a surface of the oxide film or the like by the same method as above and then an unnecessary part of the amorphous semiconductor film is removed by removing the oxide film or the like.

Then, referring to figure 5(d), the electrically conductive metal film 12 is formed on the amorphous semiconductor film 8 or 8a and the metal film 9 by resistive heating evaporation, electron beam evaporation, sputtering or gilding. Then, referring to figure 5(e), the semiconductor laser chip 6 having the electrodes 5 and 4 formed on upper and bottom surfaces thereof, respectively, is put on the electrically conductive metal film 12 on the amorphous semiconductor film 8 or 8a with soldering material and then the assembly is heated up, while pressure is applied from above. Thus, the semiconductor laser chip 6 is fixed onto the metal film 12 and in a case where the amorphous semiconductor film 8a is formed of amorphous silicon or amorphous germanium, the alloy films are formed between the amorphous semiconductor film, the metal film 9 and the electrically conductive metal film 12. Finally, referring to figure 5(f), the gold wire 7 is bonded to the electrode 5 of the semiconductor laser chip 6 and then the semiconductor laser shown in figure 4 is completed.

Then, operation thereof in accordance with the third embodiment of the present invention will be described hereinafter.

According to the third embodiment of the present invention, the electrically conductive metal film 12 is provided in order to divide a part where a current mainly flows from a part where a heat mainly flows. In addition, since the amorphous semiconductor film is arranged only under the semiconductor laser and in the vicinity thereof, the semiconductor laser chip is prevented from receiving stress. Although the heat mainly flows through the amorphous semiconductor film, the amorphous semiconductor film has a thin thickness of approximately 300 nm (3000 Å) as described above, so that thermal resistance is not increased. On the other hand, since the electrically conductive metal film 12 and the metal film 9 have fairly high electric conductivity as compared with the amorphous semiconductor film, the current flows through the metal films 9 and 12, so that the electrical characteristic is in a good state. The metal film 9 is optional.

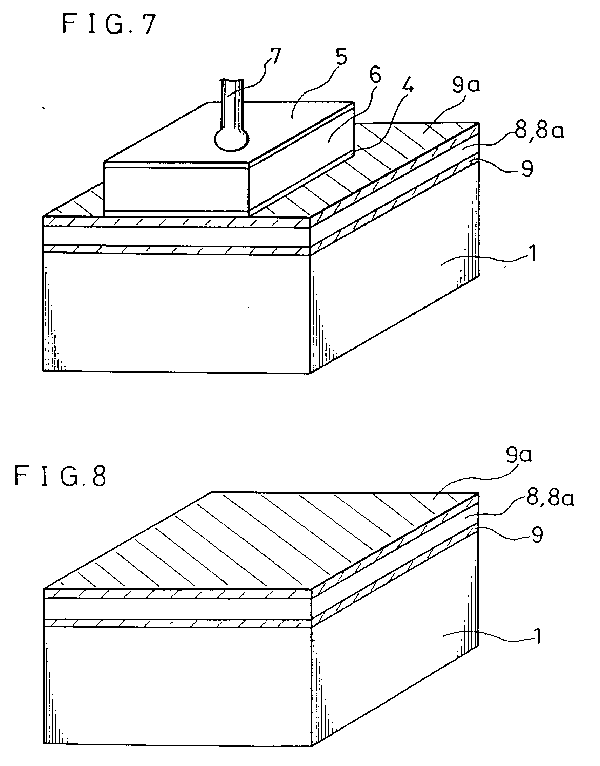

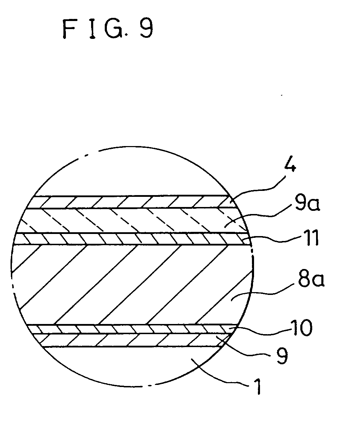

Figure 7 is a perspective view showing a semiconductor laser as a semiconductor device in accordance with a fourth embodiment of the present invention. Reference numeral 9a designates a metal film provided on the amorphous semiconductor film. According to manufacturing steps of the semiconductor device in accordance with the fourth embodiment of the present invention, as shown in figure 8, the metal film 9, the amorphous semiconductor film 8 or 8a and the metal film 9a are formed on the heat sink 1 and then they are heated up once. Since there is the metal film 9a, the amorphous semiconductor film is not oxidized at all and also in a case where the amorphous semiconductor film 8a is formed of amorphous silicon or amorphous germanium, the alloy films are surely formed between the amorphous semiconductor film and the metal films 9 and 9a as shown in figure 9, which serves as ohmic contact. As a result, the electrical characteristic can be improved.

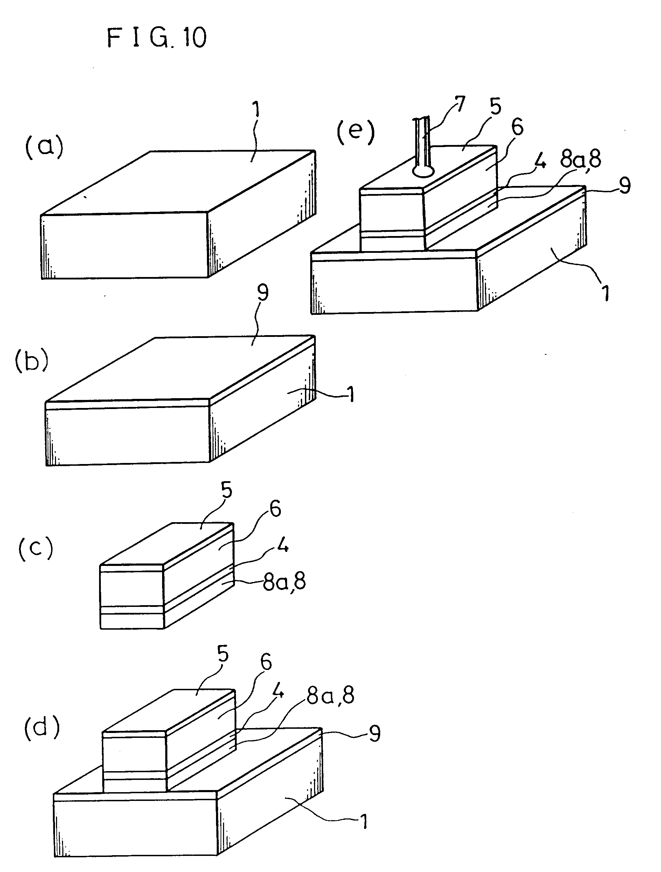

Figure 10 are views showing a semiconductor laser as a semiconductor device and its manufacturing steps in accordance with a fifth embodiment of the present invention. According to the fifth embodiment of the present invention, the amorphous semiconductor film 8 or 8a is attached onto the semiconductor laser chip side during the manufacturing steps.

Each manufacturing step thereof will be described hereinafter. First, referring to figure 10(a), the heat sink 1 is prepared. Then, referring to figure 10(b), the metal film 9 is formed on the heat sink 1. Then, referring to figure 10(c), the amorphous semiconductor film 8 (8a) is attached to a bottom surface of the semiconductor laser chip 6 having the electrodes 5 and 4 previously formed on upper and bottom surfaces thereof by electron beam evaporation or sputtering. Then, referring to figure 10(d), the semiconductor laser chip formed as shown in figure 10(c) is put on the metal film 9 and then pressure or weight is applied from above,while the assembly is heated up. Thus, in the case where the amorphous semiconductor film is formed of amorphous silicon or amorphous germanium, the alloy films are formed between the amorphous semiconductor film, the metal film 9 and the electrode 4, whereby the semiconductor laser chip is fixed onto the metal film 9. When an amorphous semiconductor film, on which an alloy metal film is not likely to be formed, is used, the laser chip can be fixed using an appropriate soldering material. Finally, referring to figure 10(e), the wire 7 is bonded to the electrode 5 of the semiconductor laser chip and then the laser is completed.

According to the fifth embodiment of the present invention, strain caused by a difference between the thermal expansion coefficients of the heat sink 1 and the semiconductor laser chip 6 is reduced due to the amorphous semiconductor film 8 or 8a and even when the amorphous semiconductor film is very thin, it has an effect of reducing the strain, with the result that thermal resistance is not increased and the life of a laser element can be increased. Furthermore, since the alloy film is formed between the amorphous semiconductor film and the metal film, the electrical characteristic can be improved.

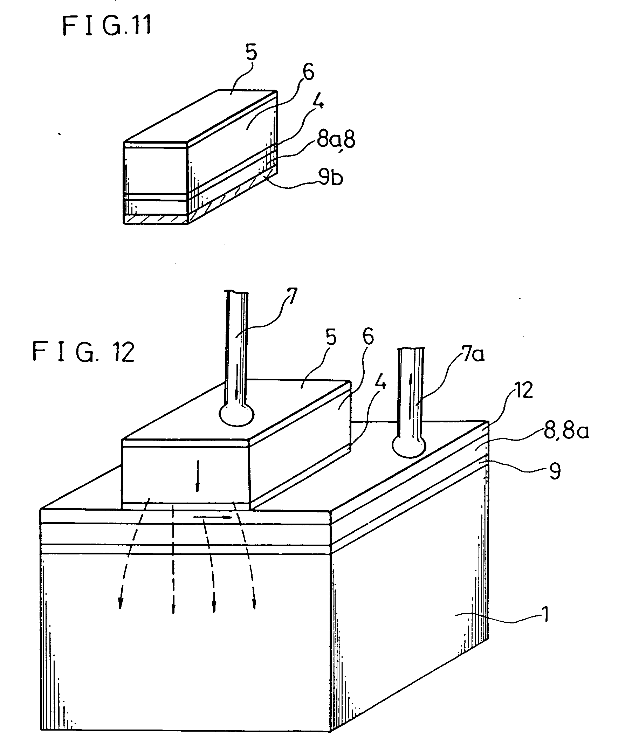

Figure 11 is a view showing a laser chip of a semiconductor laser as a semiconductor device in accordance with a sixth embodiment of the present invention before it is attached to the heat sink. According to the sixth embodiment of the present invention, a metal film 9b is further formed just after the amorphous semiconductor film is formed on the semiconductor laser chip at the step shown in figure 10(c) in the fifth embodiment of the present invention. As a result, oxidation of a surface of the amorphous semiconductor film before it is fixed to the laser chip can be prevented and then a semiconductor laser device having high thermal conductivity and electric conductivity can be obtained.

Figure 12 is a perspective view showing a semiconductor laser as a semiconductor device in accordance with a seventh embodiment of the present invention. According to the seventh embodiment of the present invention, the electrically conductive metal film 12 is formed on the whole surface of the amorphous semiconductor film and then a gild wire 7a is bonded to the metal film 12 to completely separate a current flow from a heat flow. A current flows as shown by an arrow of a solid line and a heat flows as shown by an arrow of a dotted line. As a result, any influence by the amorphous semiconductor film is not exerted on the electric conductivity.

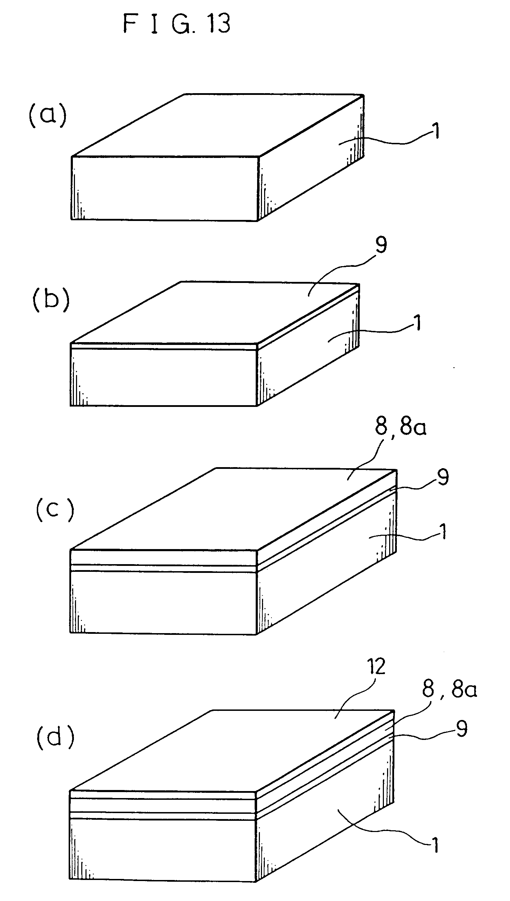

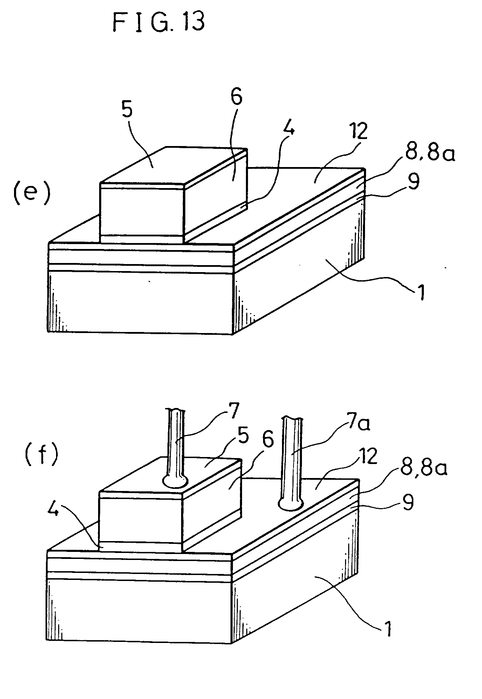

Figures 13(a) to 13(f) are perspective views showing manufacturing steps for the semiconductor laser in accordance with a seventh embodiment of the present invention. Each step is described hereinafter with reference to the figure. First, referring to figure 13(a), the heat sink 1 is prepared. Then, referring to figure 13(b), the metal film 9 is formed on the heat sink 1. Then, referring to figure 13(c), the amorphous semiconductor film 8 or 8a is formed by electron beam evaporation or sputtering. When the amorphous semiconductor film 8 or 8a is formed, the temperature of the heat sink 1 and metal film 9 is approximately 200°C. Then referring to figure 13(d), the electrically conductive metal film 12 is formed on the entire surface of the amorphous semiconductor film 8 or 8a by resistive heating evaporation, electron beam evaporation or sputtering. They can be heated up once in this state to form the alloy films between the amorphous semiconductor film 8 or 8a and the metal films 9 and 12. Thereafter, referring to figure 13(e), the semiconductor laser chip 6 having the electrodes 5 and 4 previously formed on upper and bottom surfaces thereof, respectively, is put on the electrically conductive metal film 12. Then, pressure or weight is applied from above, while the whole is heated up, so that the laser chip is fixed onto the metal film 12. If there was no heat treatment at the previous step, that is, the step shown in figure 13(d), the alloy films are formed between the amorphous semiconductor film 8 or 8a and the metal films 9 and 12 at the step shown in figure 13(e). Finally, referring to figure 13(f), the gold wires 7 and 7a are bonded to the electrode 5 of the semiconductor laser chip and the electrically conductive metal film 12. Thus, the semiconductor laser shown in figure 12 is completed.

Although a description was given of the semiconductor laser device in the above embodiments, the present invention is not limited thereto. The same effect can be obtained even when the present invention is applied to any semiconductor device in which the semiconductor element is arranged on the heat sink and stress is generated when it is constructed or the element operates.

Although the present invention has been described and illustrated in detail, it is clearly understood that the same is by way of illustration and example only and is not to be taken by way of limitation, the scope of the present invention being limited only by the terms of the appended claims.

## Claims

1. A semiconductor device comprising:
a heat sink (1) for radiating heat; and
a semiconductor element (6), of a type generating heat during its operation, mounted on a major surface of said heat sink (1);
which semiconductor device is characterised by:
an amorphous semiconductor film (8;8a) located between said heat sink (1) and said semiconductor element (6).

2. A semiconductor device, as claimed in claim 1, wherein:
said amorphous semiconductor film (8a) is of amorphous silicon, or of amorphous germanium; and
first and second metal films (9,4) are disposed between said heat sink (1) and said amorphous semiconductor film (8a) and between said amorphous semiconductor film (8a) and said semiconductor element (6), respectively, which first and second metal films (9,4) are in ohmic contact with said amorphous semiconductor film (8a) and provide bonding between said amorphous semiconductor film (8a) and said heat sink (1) and said semiconductor element (6), respectively.

3. A semiconductor device in accordance with claim 2 wherein respective alloy films (10,11) are formed between said amorphous semiconductor film (8a) and said first metal film (9) and between said amorphous semiconductor film (8a) and said second metal film (4).

4. A semiconductor device in accordance with claim 3 wherein said second metal film (4) is a gold gilding film formed on said amorphous semiconductor film (8a).

5. A semiconductor device in accordance with claim 3 wherein said second metal film (4) is a gold gilding film formed on a surface of an electrode of said semiconductor element (6) at the side in contact with said amorphous semiconductor film (8a).

6. A semiconductor device, as claimed in claim 1, wherein:
said amorphous semiconductor film (8a) is located only on a region of the major surface of said heat sink (1) where said semiconductor element (6) is mounted; and
a metal film (12) of lower electrical resistance than that of said amorphous semiconductor film (8a) is disposed on said amorphous semiconductor film (8a) and the remainder of the major surface of said heat sink (1).

7. A semiconductor device, as claimed in claim 1, wherein:
said amorphous semiconductor film (8a) covers the major surface of said heat sink (1); and
a metal film (9a;12) is disposed on said amorphous semiconductor film (8a).

8. A semiconductor device as claimed in either of claims 6 or 7 wherein said metal film (12;9a) is a gold gilding film.

9. A semiconductor device as claimed in claim 7 including a current supply wire (7a) directly bonded to said metal film (12).

10. A semiconductor device as claimed in any preceding claim wherein said amorphous semiconductor film is of thickness 300 nm (3000 Å).

11. A method for manufacturing a semiconductor device having a function of radiating heat generated therein, comprising the steps of:
forming a first metal film (9) on a heat sink (1) for radiating heat;
forming an amorphous semiconductor film (8,8a) on said first metal film (9) and then forming a second metal film (9a) on said amorphous semiconductor film (8,8a);
placing a semiconductor element (6) on said second metal film (9a); and
urging said semiconductor element (6) and said second metal film (9a) together and heating at the same time, to bond said semiconductor element (6) to said heat sink (1).

12. A method as claimed in claim 11 wherein respective alloy films (10,11) are formed between said amorphous semiconductor film (8,8a) and said first and second metal films (9,9a).

13. A method for manufacturing a semiconductor device in accordance with either of claims 11 or 12 wherein said amorphous semiconductor film (8,8a) is formed of amorphous silicon or amorphous germanium.

14. A method for manufacturing a semiconductor device in accordance with claim 13 wherein said amorphous semiconductor film (8,8a) is formed by electron beam evaporation or sputtering.

15. A method for manufacturing a semiconductor device in accordance with claim 14 wherein the temperature of the heat sink (1) and first metal film (9) is 200°C when said amorphous semiconductor film (8;8a) is formed.

16. A method for manufacturing a semiconductor device as claimed in claim 13 wherein said second metal film (9a) is a gold gilding film formed on a surface of an electrode of said semiconductor element (6) facing said amorphous semiconductor film (8,8a).

## Patentansprüche

1. Eine Halbleitervorrichtung mit:
einer Wärmesenke (1) zur Abstrahlung von Wärme; und
einem Halbleiterelement (6) des Typs, der während seines Betriebs Wärme erzeugt und das auf einer Hauptoberfläche der Wärmesenke (1) angeordnet ist;
wobei die Halbleitervorrichtung gekennzeichnet ist durch:
einen amorphen Halbleiterfilm (8;8a), der zwischen der Wärmesenke (1) und dem Halbleiterelement (6) angeordnet ist.

2. Eine Halbleitervorrichtung nach Anspruch 1, wobei:
der amorphe Halbleiterfilm (8a) aus amorphem Silizium oder amorphem Germanium ist; und
erste und zweite Metallfilme (9,4) zwischen der Wärmesenke (1) und dem amorphen Halbleiterfilm (8a) bzw. dem amorphen Halbleiterfilm (8a) und dem Halbleiterelement (6) angeordnet sind, wobei die ersten und zweiten Metall filme (9,4) in ohm'schen Kontakt mit dem amorphen Halbleiterfilm (8a) sind und eine Verbindung zwischen dem amorphen Halbleiterfilm (8a) und der Wärmesenke (1) bzw. dem Halbleiterelement (6) bereitstellen.

3. Eine Halbleitervorrichtung nach Anspruch 2, wobei entsprechende Legierungsfilme (10,11) zwischen dem amorphen Halbleiterfilm (8a) und dem ersten Metallfilm (9) und zwischen dem amorphen Halbleiterfilm (8a) und dem zweiten Metallfilm (4) gebildet sind.

4. Eine Halbleitervorrichtung nach Anspruch 3, wobei der zweite Metallfilm (4) ein Vergoldungsfilm ist, der auf dem amorphen Halbleiterfilm (8a) gebildet ist.

5. Eine Halbleitervorrichtung nach Anspruch 3, wobei der zweite Metallfilm (4) ein Vergoldungsfilm ist, der auf einer Oberfläche einer Elektrode des Halbleiterelementes (6) auf der Seite gebildet ist, die in Kontakt mit dem amorphen Halbleiterfilm (8a) ist.

6. Eine Halbleitervorrichtung nach Anspruch 1, wobei:
der amorphe Halbleiterfilm (8a) nur in einem Bereich der Hauptoberfläche der Wärmesenke (1) angeordnet ist, wo das Halbleiterelement (6) angeordnet ist; und
ein Metallfilm (12) mit geringerem elektrischen Widerstand als der amorphe Halbleiterfilm (8a) auf dem amorphen Halbleiterfilm (8a) und dem Rest der Hauptoberfläche der Wärmesenke (1) angeordnet ist.

7. Eine Halbleitervorrichtung nach Anspruch 1, wobei:
der amorphe Halbleiterfilm (8a) die Hauptoberfläche der Wärmesenke (1) bedeckt; und
ein Metallfilm (9a;12) auf dem amorphen Halbleiterfilm (8a) angeordnet ist.

8. Eine Halbleitervorrichtung nach einem der Anprüche 6 oder 7, wobei der Metallfilm (12; 9a) ein Vergoldungsfilm ist.

9. Eine Halbleitervorrichtung nach Anspruch 7 mit einem Stromzufuhrdraht (7a) der direkt an den Metallfilm (12) gebondet ist.

10. Eine Halbleitervorrichtung nach einem der vorhergehenden Ansprüche, wobei der amorphe Halbleiterfilm eine Dicke von 300 nm (3000 Å) hat.

11. Ein Verfahren zur Herstellung einer Halbleitervorrichtung, welche hierin erzeugte Wärme abstrahlt, mit den folgenden Schritten:
Ausbilden eines ersten Metallfilms (9) auf einer Wärmesenke (1) zur Wärmeabstrahlung;
Ausbilden eines amorphen Halbleiterfilms (8, 8a) auf dem ersten Metallfilm (9) und dann Ausbilden eines zweiten Metallfilms (9a) auf dem amorphen Halbleiterfilm (8, 8a);
Anordnen eines Halbleiterelementes (6) auf dem zweiten Metallfilm (9a); und
Zusammenspannen des Halbleiterelementes (6) und des zweiten Metallfilms (9a) mit gleichzeitigem Erwärmen, um das Halbleiterelement (6) auf die Wärmesenke (1) zu bonden.

12. Ein Verfahren nach Anspruch 11, wobei entsprechende Legierungsfilme (10, 11) zwischen dem amorphen Halbleiterfilm (8, 8a) und den ersten und zweiten Metallfilmen (9, 9a) ausgebildet werden.

13. Ein Verfahren zur Herstellung einer Halbleitervorrichtung nach einem der Ansprüche 11 oder 12, wobei der amorphe Halbleiterfilm (8, 8a) aus amorphem Silizium oder amorphem Germanium gebildet wird.

14. Ein Verfahren zur Herstellung einer Halbleitervorrichtung nach Anspruch 13, wobei der amorphe Halbleiterfilm (8, 8a) durch Elektronenstrahlverdampfung oder Sputtern gebildet wird.

15. Ein Verfahren zur Herstellung einer Halbleitervorrichtung nach Anspruch 14, wobei die Temperatur der Wärmesenke (1) des ersten Metallfilms (9) beim Ausbilden des amorphen Halbleiterfilms (8; 8a) 200°C beträgt.

16. Ein Verfahren zur Herstellung einer Halbleitervorrichtung nach Anspruch 13, wobei der zweite Metallfilm (9a) ein Vergoldungsfilm ist, der auf einer Oberfläche einer Elektrode des Halbleiterelementes (6) ausgebildet ist, die in Richtung des amorphen Halbleiterfilms (8, 8a) weist.

## Revendications

1. Dispositif à semi-conducteur comprenant :
un dissipateur thermique (1) pour rayonner de la chaleur; et
un élément à semi-conducteur (6), d'un type produisant de la chaleur pendant son fonctionnement, monté sur une surface principale dudit dissipateur thermique (1);
lequel dispositif à semi-conducteur est caractérisé par:
un film semi-conducteur amorphe (8;8a) situé entre ledit dissipateur thermique (1) et ledit élément à semi-conducteur (6).

2. Dissipateur à semi-conducteur, comme revendiqué en revendication 1, dans lequel :
le film semi-conducteur amorphe précité (8a) est du silicium amorphe ou du germanium amorphe; et
des premier et second films métalliques (9,4) sont disposés entre le dissipateur thermique précité (1) et ledit film semi-conducteur amorphe (8a) et entre ledit film semi-conducteur amorphe (8a) et l'élément à semi-conducteur précité (6), respectivement, lesquels premier et second films métalliques (9,4) sont en contact ohmique avec ledit films semi-conducteur amorphe (8a) et produisent une liaison entre ledit film semi-conducteur amorphe (8a) et ledit dissipateur thermique (1) et ledit élément à semi-conducteur (6), respectivement.

3. Dispositif à semi-conducteur selon la revendication 2 dans lequel des films d'alliage respectifs (10,11) sont formés entre le film semi-conducteur amorphe précité (8a) et le premier film métallique précité (9) et entre ledit film semi-conducteur amorphe (8a) et le second film métallique précité (4).

4. Dispositif à semi-conducteur selon la revendication 3 dans lequel le second film métallique précité (4) est un film de dorure d'or formé sur le film semi-conducteur amorphe précité (8a).

5. Dispositif à semi-conducteur selon la revendication 3, dans lequel le second film métallique précité (4) est un film de dorure d'or formé sur une surface d'une électrode de l'élément à semi-conducteur précité (6) au côté en contact avec le film semi-conducteur amorphe précité (8a).

6. Dispositif à semi-conducteur, comme revendiqué en revendication 1, dans lequel :
le film semi-conducteur amorphe précité (8a) est situé seulement sur une région de la surface principale du dissipateur thermique précité (1) où l'élément à semi-conducteur (6) précité est monté; et
un film métallique (12) de résistance électrique plus faible que celle dudit film à semi-conducteur amorphe (8a) est disposé sur ledit film semi-conducteur amorphe (8a) et le restant de la surface principale dudit dissipateur thermique (1).

7. Dispositif à semi-conducteur, comme revendiqué en revendication 1, dans lequel :
le film semi-conducteur amorphe précité (8a) recouvre la surface principale du dissipateur thermique précité (1); et
un film métallique (9a;12) est disposé sur ledit film semi-conducteur amorphe (8a).

8. Dispositif à semi-conducteur comme revendiqué dans l'une ou l'autre des revendications 6 ou 7, dans lequel le film métallique précité (12;9a) est un film de dorure d'or.

9. Dispositif à semi-conducteur comme revendiqué en revendidication 7 comprenant un fil d'alimentation en courant (7a) directement lié au film métallique précité (12).

10. Dispositif à semi-conducteur comme revendiqué dans l'une quelconque des revendications précédentes, dans lequel le film semi-conducteur amorphe précité est d'une épaisseur de 300 nm (3000 Å).

11. Procédé pour fabriquer un dispositif à semi-conducteur ayant une fonction de rayonnement de chaleur produite dans celui-ci, comprenant les étapes de :
former un premier film métallique (9) sur un dissipateur thermique (1) pour rayonner de la chaleur;
former un film semi-conducteur amorphe (8,8a) sur ledit premier film métallique (9) et ensuite former un second film métallique (9a) sur ledit film semi-conducteur amorphe (8,8a);
placer un élément à semi-conducteur (6) sur ledit second film métallique (9a); et
sollicier ledit élément à semi-conducteur (6) et ledit second film métallique (9a) ensemble et chauffer en même temps pour lier ledit élément à semi-conducteur (6) audit dissipateur thermique (1).

12. Procédé comme revendiqué en revendication 11, dans lequel des films d'alliage respectifs (10,11) sont formés entre le film semi-conducteur amorphe précité (8,8a) et les premier et second films métalliques précités (9,9a).

13. Procédé pour fabriquer un dispositif à semi-conducteur selon l'une ou l'autre des revendications 11 ou 12, dans lequel le film semi-conducteur amorphe précité (8,8a) est formé de silicium amorphe ou de germanium amorphe.

14. Procédé pour fabriquer un dispositif à semi-conducteur selon la revendication 13, dans lequel le film semi-conducteur amorphe précité (8,8a) est formé par évaporation de faisceau d'électrons ou pulvérisation.

15. Procédé pour fabriquer un dispositif à semi-conducteur selon la revendication 14, dans lequel la température du dissipateur thermique (1) et du premier film métallique (9) est de 200°C lorsque le film semi-conducteur amorphe précité (8,8a) est formé.

16. Procédé pour fabriquer un dispositif à semi-conducteur comme revendiqué en revendication 13, dans lequel le second film métallique précité (9a) est un film de dorure d'or formé sur une surface d'une électrode de l'élément à semi-conducteur précité (6) faisant face au film semi-conducteur amorphe précité (8,8a).
